(19) Europäisches Patentamt
European Patent Office
Office européen des brevets

(11) EP 2 219 073 B1

# (12) EUROPÄISCHE PATENTSCHRIFT

(45) Veröffentlichungstag und Bekanntmachung des Hinweises auf die Patenterteilung:
**03.06.2020 Patentblatt 2020/23**

(51) Int Cl.:
*G03F 7/00* (2006.01) *G03F 7/028* (2006.01)
*G03F 7/035* (2006.01) *G03H 1/02* (2006.01)

(21) Anmeldenummer: **09002180.9**

(22) Anmeldetag: **17.02.2009**

## (54) Holografische Medien und Photopolymerzusammensetzungen

Holographic media and photopolymer compositions

Supports holographiques et compositions de photopolymère

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**18.08.2010 Patentblatt 2010/33**

(73) Patentinhaber: **Covestro Deutschland AG**
**51373 Leverkusen (DE)**

(72) Erfinder:
- **Fäcke, Thomas**
  **51375 Leverkusen (DE)**
- **Bruder, Friedrich-Karl**
  **47802 Krefeld (DE)**
- **Weiser, Marc-Stephan**
  **51379 Leverkusen (DE)**
- **Roelle, Thomas**
  **51381 Leverkusen (DE)**
- **Hönel, Dennis**
  **53909 Zülpich (DE)**

(74) Vertreter: **Levpat**
**c/o Covestro AG**
**Gebäude 4825**
**51365 Leverkusen (DE)**

(56) Entgegenhaltungen:
**EP-A- 1 701 213** **WO-A-2008/125200**
**JP-A- 2004 118 050** **JP-A- 2004 342 537**
**JP-A- 2005 194 476** **JP-A- 2005 239 925**

- **BUKOWSKA A. AND BUKOWSKI W.: "Kinetic Study of Addition of Some Carboxylic Acids to 1,2-Epoxy-3-phenoxypropane" ORGANIC PROCESS RESEARCH & DEVELOPMENT, Bd. 3, Nr. 36, 1. Oktober 1999 (1999-10-01), Seiten 432-436, XP002526237**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 219 073 B1

## Beschreibung

Die Erfindung betrifft holografische Medien enthaltend spezielle Photopolymere, ein Verfahren zu deren Herstellung.

Photopolymere - also Materialien, die durch Licht polymerisieren - finden breiteste Anwendung wie z.B. in der Lackierung von zumeist ebenen Substraten wie Papier und Holz in der Möbel, Folien, Parkett oder Druckindustrie. Zudem gibt es viele weitere Spezialanwendungen. Klassisch verwendete Materialien sind Ester der (Meth)acrylsäure, Polyesteracrylate, Epoxyacrylate und Urethanacrylate. Eine eher selten beschriebene Substanzklasse stellen dabei die Glycidyletheracrylaturethane dar. EP 44352 lehrt z.B. über deren Verwendung in Dentalmassenkompositionen enthaltend Alkylglycidylethermethacrylaturethane - und Phenylglycidylethermethacrylaturethane. JP 118475 beschreibt die Herstellung von Kunststofflinsen basierend auf halogenierten Methylphenylglycidetheracrylaturethanen. Die Herstellung von optischen Elementen mit polarisierenden Eigenschaften lehrt JP 2006243416, in der nicht polymerisierende flüssigkristalline Materialien mit polymerisierenden ungesättigten Materialien, wie Ester ungesättigter Säuren mit aliphatischer Polyole und Amide ungesättigter Säuren mit aliphatischen Polyaminen, sowie die oben erwähnten Polyesteracrylate, Epoxyacrylate und Urethanacrylate kombiniert werden. In einer beschriebenen Ausführungsform wird dafür ein Phenylglycidyletheracrylaturethan auf Basis von Hexamethylendiisocyanat verwendet. Diese Formulierungen sind flüssiger Natur und müssen nach Applikation sofort mit Licht polymerisiert werden.

Spezielle Photopolymere eignen sich zur Herstellung von Volumenhologrammen, die mittels Belichtung durch kohärente Strahlungsquellen wie z.B. Laserstrahlung, strukturiert werden. Dabei bildet sich eine dreidimensionale Struktur in den Photopolymeren aus, die sich im Allgemeinen durch eine regionale Änderung des Brechungsindexes in dem Material beschreiben lässt. Ein Hologramm ist somit ein Objekt, das eine periodische, räumliche Modulation des Brechungsindex enthält. Dabei hängt es von der speziellen Belichtung ab, welche optische Funktion ein solches Hologramm ausbildet, z.B. ein dreidimensional Bild darstellt oder als diffraktives optisches Element eingesetzt werden kann.

Für die Anwendung von Photopolymeren als Träger von Hologrammen für optische Anwendungen im sichtbaren Bereich werden in der Regel nach der Belichtung farblose oder lediglich sehr schwach gefärbte Materialien mit einer hohen Beugungswirkung gefordert. Seit den Anfängen der Holographie werden Silberhalogenidfilme insbesondere diejenigen mit hohem Auflösungsvermögen hierfür verwendet. Auch Dichromatgelatine (DCG), Dichromatsalz-haltige Gelatinefilme, oder auch Mischformen aus Silberhalogenid und DCG werden verwendet. Beide Materialien benötigen eine chemische Nachbehandlung zur Bildung eines Hologramms, was für industrielle Prozesse zusätzliche Kosten erzeugt und den Umgang mit chemischen Entwicklerlösungen erforderlich macht. Zudem haben nasschemische Verfahren den Nachteil, beim Einwirken der Entwicklerlösungen ein Quellen zu verursachen. Beim nachfolgenden Trocknen folgt ein Schrumpfen des Filmes. Dies führt meist zu Farbverschiebungen und Unregelmäßigkeiten in der Hologrammabbildung, was unerwünscht ist. Obwohl technisch dieses nasschemische Verfahren realisierbar ist, hat die Erfahrung der holografischen Industrie gezeigt, dass hohe Ausschussraten bedingt durch die Komplexizität und erforderliche Präzision des Prozesses zu unakzeptablen hohen Kosten führt.

Es wurden verschiedene Ansätze gemacht, die obigen Materialen zu ersetzen. US 4959284 (Dupont) beschreibt Photopolymere, die u.a. aus einem in organischen Lösungsmitteln löslichen Thermoplasten wie Polyvinylacetat, Celluloseacetobutyrat oder Polymethylmethacrylat-StyrolCopolymere, einem Photoinitiator und mindestens einem Vinylcyclopropanderivat bestehen. In EP352774A1 (Dupont) werden zudem andere Vinylgruppen-haltigen Monomere beschrieben wie N-Vinylpyrrolidon, Phenoxyethylacrylat und Acrylester von Triolen wie Trimethylolpropan (TMPTA) und ethoxylierten Trimethylolpropan (TMPEOTA) oder andere Acrylester oder Acrylamide.

In jüngerer Zeit wurden zudem Photopolymere beschrieben, die nicht aus Thermoplasten, sondern aus vernetzten Polymeren enthalten werden: US 6103454 (InPhase) beschreibt eine Polyurethanmatrix mit polymerisierbaren Komponenten wie 4-Chlorphenylacrylat, 4-Bromstryrol und Vinylnaphthalen. Diese Formulierungen wurden für die holographische Datenspeicherung entwickelt, eine holographischen Anwendung, in der man viele, aber auch sehr schwache, nur mit elektronischen Detektoren lesbare Hologramme einschreibt und ausliest. Holografische Medien auf Basis derartiger Material eignen sich nicht zur Herstellung von visuell sichtbaren Hologrammen.

JP 2005 239925 A offenbart härtbares Material mit einem hohen Brechungsindex und Schichtverbünde hergestellt durch die Verwendung von härtbarem Material mit einem hohen Brechungsindex.

JP 2005 194476 A offenbart eine photosensitive Zusammensetzung.

JP 2004 118050 A offenbart eine photosensitive Harzzusammensetzung und deren Verwendung in einen Verfahren zur Herstellung von anorganischen Artikeln.

JP 2004 342537 A offenbart Gelelektrolyte und deren Verwendung in nicht-wässrigen Elektrolytbatterien.

Aufgabe war es nun holografische Medien bereitzustellen, die sich bei Raumtemperatur erst unter kohärenter Strahlung entwickeln und keine thermische oder chemische Nachbehandlung benötigen. Weiterhin war es die Aufgabe hierzu polymerisierbare Schreibmonomere bereitzustellen, die sich besonders gut zur Herstellung in derartigen Photopolymerkompositionen eignen. Dabei war es wichtig polymerisierende Schreibmonomere zu finden, die sich besonders gut in den Binder einlösen lassen.

Es wurde nun überraschenderweise gefunden, dass die obigen Anforderungen sehr gut erfüllt werden, wenn man Glycidyletheracrylaturethane als Schreibmonomere verwendet und diese in ein Bindersystem enthaltende Polymerkomposition einarbeitet.

Gegenstand der Erfindung sind daher Photopolymerzusammensetzungen umfassend

a) mindestens ein ungesättigtes Glycidyletheracrylaturethan der allgemeinen Formel (1a) oder (1b) oder Mischungen aus (1a) und (1b)

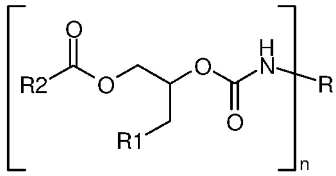

Formel 1a

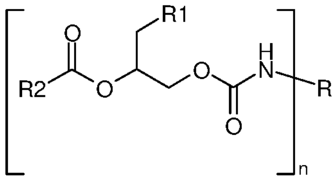

Formel 1b

wobei

n eine natürliche Zahl von 2 bis 6 ist

R1 ein ein- oder mehrkerniger Aromatengruppen haltiger organischer Rest mit 4 bis 36 Kohlenstoffatomen ist,

R2 ein olefinisch ungesättigter Rest mit 3 bis 30 Kohlenstoffatomen ist und

R ein von einem aliphatischen oder aromatischen Di- oder Polyisocyanat abgeleiteter organischer Rest mit 2 bis 30 Kohlenstoffatomen ist.

b) ein Bindersystem

c) mindestens ein Photoinitiatorsystem

d) ggf. Radikalstabilisatoren, Katalysatoren und weitere Zusatzstoffe, dadurch gekennzeichnet, dass das Photoinitiatorsystem aus einer Mischung aus einem Ammoniumarylborat und einem oder mehreren Farbstoffen besteht, wobei in b) vernetzte Binder eingesetzt werden, wobei der vernetzte Binder ein zweikomponentiges Polyurethansystem ist und das zweikomponentige Polyurethansystem als Isocyanatkomponente Oligo- und Polyisocyanate aliphatischer Diisocyanate mit Isocyanurat-, Allophanat-, Biuret-, Uretdion-, Iminooxadiazindionstruktur und die Polyolkomponente Polyethylen/Polypropylenglykole mit einem Polypropylengehalt von mindestens 70% und einer Funktionalität von 1.9 bis 2.5 und/oder Polyester-Polyether-Polyester-Blockpolyole auf Basis von Polytetrahydrofuranen mit einem zahlenmittleren Molekulargewicht von 400 bis 1400 g/mol und ε-Caprolacton umfasst, wobei diese Polyester-Polyether-Polyester-Blockpolyole ein zahlenmittleres Molekulargewicht von 1500 bis 4000 g/mol haben.

Ein weiterer Gegenstand der Erfindung ist ein Verfahren zur Herstellung von Medien zur Aufzeichnung visueller Hologramme, bei dem die erfindungsgemäßen Photopolymerzusammensetzungen auf ein Substrat oder in eine Form appliziert und ausgehärtet werden. Ferner sind Gegenstände der Erfindung daraus erhältliche Medien zur Aufzeichnung visueller Hologramme sowie deren Verwendung als optische Elemente, Bilder oder zur Bilddarstellung oder -projektion. Ebenfalls ist ein Verfahren zur Aufzeichnung eines Hologramms, bei dem solche Medien eingesetzt werden, Gegenstand der Erfindung.

Die ungesättigten Glycidyletheracrylaturethane der Formel 1a bzw. 1b können in einer 2-Stufen Synthese hergestellt werden. In der ersten Umsetzung wird eine ungesättigte Säure R2-COOH mit einem Epoxid $R1-CH_2-CHOCH_2$

zur Reaktion gebracht, wobei ein Gemisch zweier Alkohole nach Formel 3 gebildet wird.

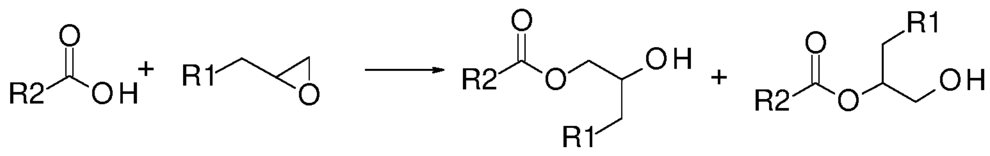

Formel 3

In einem zweiten Reaktionsschritt wird das Alkoholgemisch mittels eines Di- oder Polyisocyanats $R(NCO)_n$ der Funktionalität n zu dem erfindungsgemäßen Glycidyletheracrylaturethan urethanisiert (Formel 4).

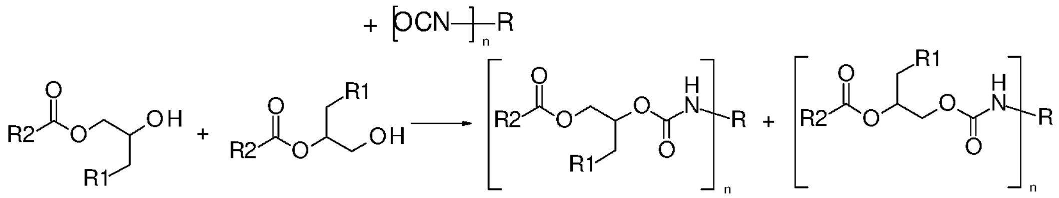

Formel 4

Als Epoxide der allgemeinen Formel $R1\text{-}CH_2\text{-}CHOCH_2$ eignen sich Reste R1, die eine ein- oder mehrkernige Aromatengruppen enthalten, mit 4 bis 36 Kohlenstoffatomen, bevorzugt 5 bis 20 Kohlenstoffatomen, besonders bevorzugt 6 bis 16 Kohlenstoffatomen.

So sind dies insbesondere substituierte Oxy-phenylreste mit einem bis zu fünf gleichen oder verschiedenen Substituenten am Phenylring wie Chlor, Brom, Jod, Methyl, Ethyl, n- und Isopropyl, n-, iso- und tert.- Butyl, Phenyl-, Aryloxy-, Benzoyl, Acyl-, Methoxy-, Benzyl, Methylthio-, Ethylthio, Propylthio, Butylthio, Phenylthio, Naphtylthio und Napthyl.

Weiterhin können mehrkernige aromatische und heteroaromatische Reste R1 verwendet werden wie Oxy-naphtyl, Oxy-napthylmethyl, Oxy-anthracenyl, Oxy-phenantryl, N-Carbazolyl, N-Alkylcarbazolzyl, N-Phthalimidyl, N-Phenothiazinzyl, N-Alkylphenothiazinyl, Oxy-triarylmethyl wie z.B. Oxy-triphenylmethyl. Ebenso können diese mehrkernige aromatische und heteroaromatische Reste R1 zudem substituiert sein wie z.B. mit Substituenten wie Chlor, Brom, Jod, Methyl, Ethyl, n- und Isopropyl, n-, iso- und tert.- Butyl, Phenyl-, Aryloxy-, Benzoyl, Acyl-, Methoxy-, Benzyl, Methylthio-, Ethylthio, Propylthio, Butylthio, Phenylthio, Naphtylthio und Napthyl.

Bevorzugte Reste R1 sind Oxy-phenyl, Oxy-bromphenyl, Oxy-dibromphenyl und Oxy-naphtyl, besonders bevorzugt sind Oxy-phenyl, Oxy-dibromphenyl und Oxy-naphtyl.

Die Säuren R2-COOH enthalten einen ungesättigten Rest R mit 2 bis 30 Kohlenstoffatomen, bevorzugt 2 bis 20 Kohlenstoffatomen, besonders bevorzugt 2 bis 9 Kohlenstoffatomen. Als Säuren R2-COOH eignen sich Acrylsäure, Methacrylsäure, 3-Acryloxypropionsäure, Zimtsäure, Crotonsäure sowie Addukte aus einem Monoanhydrid mit Hydroxyethyl(meth)acrylat, Hydroxypropyl(meth)acrylat und Hydroxybutylacrylat. Dabei sind geeignete Monoanhydride: Maleinsäureanhydrid, Bernsteinsäureanhydrid, Itaconsäureanhydrid, Tetrahydrophthalsäureanhydrid, 5-Norbornen-endo,2,3-dicarbonsaeureanhydrid, Hexahydrophthalsäureanhydrid; Phenylbernsteinsäureanhydrid, Benzylbernsteinsäureanhydrid, Isatoicanhydrid, Bromoisatoicanhydrid, Bromphthalsäureanhydride, Chlorphthalsäureanhydrid, Tetrabromophthalsäureanhydrid, Tetrachlorophthalsäureanhydrid, 4-Bromo-1,8-naphthalicanhydride, Mono and dibromomaleinsäureanhydrid, Diphenylmaleinsäure anhydrid, 5-Norbornene-2,3-dicarboxylanhydride, 2,3-Naphthalicanhydrid, 1,8-Naphthalicanhydride, exo-3,6-Methylene-1,2,3,6-tetrahydrophthalsäure-anhydride und Tetraphenylphthalsäureanhydride.

Bevorzugt sind Acrylsäure, Methacrylsäure, 3-Acryloxypropionsäure sowie die Addukte von Hydroxyethyl- und Hydroxybutylacrylat mit Maleinsäureanhydrid.

Besonders bevorzugt sind Acrylsäure, Methacrylsäure und 3-Acryloxypropionsäure.

Als Polyisocyanate $R(NCO)_n$ eignen sich alle dem Fachmann an sich bekannten aliphatischen, cycloaliphatischen, aromatischen oder araliphatischen Di- und Polyiisocyanate. Diese werden in bekannter Weise aus Di- oder Triaminen hergestellt, wobei es unerheblich ist, ob diese mittels Phosgenierung oder nach phosgenfreien Verfahren erhalten wurden. Der Rest R ist dabei ein organischer Rest mit 2 bis 30 Kohlenstoffatomen, bevorzugt 4 bis 30 Kohlenstoffatomen, besonders bevorzugt 6 bis 24 Kohlenstoffatomen.

Beispielsweise geeignete Isocyanate sind Butylendiisocyanat, Hexamethylendiisocyanat (HDI), 1,8-Octamethylendiisocyanat, 1,11 -Undecamethylendiisocyanat, 1,12-Dodekamethylendiisocyanat, 2,2,4 bzw. 2,4,4-Trimethyl-1,6-hexamethylendiisocyanat (TMDI), 1,3- und 1,4-Cyclohexandiisocyanat, 1-Isocyanato-3-Isocyanatomethyl-3,5,5-trimethylcyclohexan (IPDI), 1-Isocyanato-1-methyl-4(3)-isocyanatomethylcyclohexan (IMCI), 1,4-Phenylendiisocyanat, 1,5-Naphtylendiisocyanat, 1-Isocyanato-2-isocyanatomethylcyclopentan, (4,4'- und/oder 2,4'-) Diisocyanato-dicyclohexylmethan (H12-MDI, W), Bis-(4-Isocyanato-3-methylcyclohexyl)-methan, Xylylendiisocyanat (XDI), Tetramethyl-1,3- und/oder -1,4-xylylendiisocyanat (TMXDI), 1,3- und/oder 1,4-Hexahydro-xylylendiisocyanat (H6-XDI), 2,4- und/oder 2,6-hexahydrotoluylendiisocyanat (H6-TDI), 2,4- und/oder 2,6-Toluoldiisocyanat (TDI), 4,4'- und/oder 2,4'- Diphenylmethandiisocyanat (MDI), Norbornanediisocyanat, Isocyanatomethyl-1,8-octandiisocyanat (TIN) und 1,8-Diisocyanato-4-(isocyanatomethyl)oktan, Triphenylmethane 4,4',4"-triisocyanat und Tris(p-isocyanatophenyl) thiophosphate (RFE), 1-Methyl-benzene- 2,4,6-triisocyanate, Naphthalin-1,3,7-triisocyanat und dessen Isomere , Biphenyl-2,4,4'-triisocyanat und dessen Isomere, 2,4,4'- Diphenylmethantriisocyanat und dessen Isomere.

Daneben können auch die dem Fachmann an sich gut bekannten höhermolekularen Folgeprodukte monomerer Di- und/oder Triisocyanate mit Carbodiimid-, Acylharnstoff-, Isocyanurat-, Allophanat-, Biuret-, Oxadiazintrion-, Uretdion-, Iminooxadiazindionstruktur eingesetzt werden.

Besonders bevorzugt sind 2,6-Hexamethylendiisocyanat, 2,4,4-Trimethyl-1,6-hexamethylendiisocyanat, Isocyanatomethyl-1,8-octandiisocyanat, Tris(p-isocyanatophenyl) thiophosphate, Tris(4,4'- und/oder 2,4'-) Diisocyanato-dicyclohexylmethan, 1-Isocyanato-3-Isocyanatomethyl-3,5,5-trimethylcyclohexan, Diisocyanato-dicyclohexylmethan 2,4- und/oder 2,6-Toluidendiisocyanat sowie Trimerisate des Hexamethylendiisocyanats mit Isocyanurat und / oder Iminooxadiazintrionstruktur.

In einer bevorzugten Ausführungsform der Erfindung werden in a) Glycidyletheracrylaturethane eingesetzt, die einen Brechungsindex bei 405 nm von größer als 1,53, besonders bevorzugt größer als 1,55, ganz besonders bevorzugt größer als 1,555 aufweisen.

Geeignete Bindersysteme b) sind vernetzte Bindersysteme, wobei das vernetzte Bindersystem ein zweikomponentiges Polyurethansystem ist und das zweikomponentige Polyurethansystem als Isocyanatkomponente Oligo- und Polyisocyanate aliphatischer Diisocyanate mit Isocyanurat-, Allophanat-, Biuret-, Uretdion-, Iminooxadiazindionstruktur und die Polyolkomponente Polyethylen/Polypropylenglykole mit einem Polypropylengehalt von mindestens 70% und einer Funktionalität von 1.9 bis 2.5 und/oder Polyester-Polyether-Polyester-Blockpolyole auf Basis von Polytetrahydrofuranen mit einem zahlenmittleren Molekulargewicht von 400 bis 1400 g/mol und ε-Caprolacton umfasst, wobei diese Polyester-Polyether-Polyester-Blockpolyole ein zahlenmittleres Molekulargewicht von 1500 bis 4000 g/mol haben.

Für die Anwendung der Urethanvernetzung benötigt man hierzu ein Polyisocyanatvernetzer und ein hydroxyfunktionelles Harz.

Als Verbindungen der Polyisocyanatvernetzer eignen sich alle dem Fachmann an sich bekannten Oligo- und Polyisocyanate aliphatischer Diisocyanate mit Isocyanurat-, Allophanat-, Biuret-, Uretdion-, Iminooxadiazindionstruktur jeweils einzeln oder in beliebigen Mischungen untereinander eingesetzt werden.

Geeignete hydroxyfunktionelle Harze sind Polyethylen/Polypropylenglykole mit einem Polypropylengehalt von mindestens 70% und einer Funktionalität von 1.9 bis 2.5 sowie Polyester-Polyether-Polyester-Blockpolyole auf Basis von Polytetrahydrofuranen mit einem zahlenmittleren Molekulargewichts von 400 bis 1400 g/mol und ε-Caprolacton, wobei diese Polyester-Polyether-Polyester-Blockpolyole ein zahlenmittleres Molekulargewichts von 1500 bis 4000 g/mol haben.

Als Photoinitiatoren c) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxid, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29,

Pyrillium I, Cyanin und Methylenblau, Azur A:

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Die vorgenannte Einstellung hinsichtlich der Photopolymerisation ist für einen Fachmann in Form von Routineversuchen innerhalb der unten angegebenen Mengenbereiche der Komponenten sowie der jeweils zur Auswahl stehenden, insbesondere den bevorzugten Aufbaukomponenten, leicht möglich.

Bevorzugte Photoinitiatoren C) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Neben den Komponenten a) bis c) können auch Radikalstabilisatoren, Katalysatoren und weitere Zusatzstoffe mit eingesetzt werden.

Als Radikalstabilisatoren geeignet sind Inhibitoren und Antioxidantien wie sie in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-tert.-Butylchinon, ggf. auch aromatische Amine wie Diisopropylamin oder Phenothiazin. Bevorzugte Radikalstabilisatoren sind 2,6-Di-tert.-butyl-4-methylphenol, Phenothiazin und Benzhydrol.

Ferner können ein oder mehrere Katalysatoren eingesetzt werden. Diese katalysieren bevorzugt die Urethanbildung. Dazu sind bevorzugt Amine sowie Metallverbindungen der Metalle Zinn, Zink, Eisen, Bismuth, Molybdän, Kobalt, Calzium, Magnesium und Zirkonium geeignet. Besonders bevorzugt sind Zinnoctoat, Zinkoktoat, Dibutylzinndilaurat, Dimethylzinndicarboxylat, Eisen(III)-acetylacetonat, Eisen(II)-chlorid, Zinkchlorid, Tetra-alkyl-ammoniumhydroxide, Alkalihydroxide, Alkalialkoholate, Alkalisalze von langkettigen Fettsäuren mit 10 bis 20 Kohlenstoffatomen und gegebenenfalls seitenständigen OH-Gruppen, Bleioctoat oder tertiäre Amine wie Triethylamin, Tributylamin, Dimethylbenzylamin, Dicyclohexylmethylamin, Dimethyl-cyclohexylamin, N,N,N',N'-Tetramethyl-diamino-diethylether, Bis-(dimethylamino-propyl)-harnstoff, N-Methyl- bzw. N-Ethylmorpholin, N,N'-Dimorpholinodiethylether (DMDEE), N-Cyclohexylmorpholin, N,N,N',N'-Tetramethylethylendiamin, N,N,N',N'-Tetramethyl-butan-diamin, N,N,N',N'-Tetramethylhexandiamin-1,6, Pentamethyldiethylentriamin, Dimethylpiperazin, N-Dimethylaminoethylpiperidin, 1,2-Dimethylimidazol, N-Hydroxypropylimidazol, 1-Azabicyclo-(2,2,0)-octan, 1,4-Diazabicyclo-(2,2,2)-octan (Dabco) oder Alkanolaminverbindungen, wie Triethanolamin, Triisopropanolamin, N-Methyl- und N-Ethyl-diethanolamin, Dimethyl-amino-ethanol, 2-(N,N-Dimethylaminoethoxy)ethanol oder N-Tris-(dialkylaminoalkyl)hexa-hydro-triazine, z.B. N,N',N-Tris-(dimethylaminopropyl)-s-hexahydrotriazin, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Besonders bevorzugte Katalysatoren sind Dibutylzinndilaurat, Dimethylzinndicarboxylat, Eisen(III)acetylacetonat, 1,4-Diazabicyclo-[2.2.2]-octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Als weitere Hilfs- und Zusatzstoffe können beispielsweise enthalten sein Lösemittel, Weichmacher, Verlaufsmittel, Benetzungsmittel, Entschäumer oder Haftvermittler, aber auch Polyurethane, thermoplastische Polymere, Oligomere, weitere funktionelle Gruppen, wie z.B. Acetale, Epoxid, Oxetane, Oxazoline, Dioxolane und/oder hydrophile Gruppen, wie z.B. Salze und/oder Polyethylenoxide, aufweisende Verbindungen.

Als Lösemittel werden dabei bevorzugt leichtflüchtige Lösemittel mit guter Verträglichkeit mit den erfindungsgemäßen 2-Komponentenformulierungen verwendet, beispielsweise Ethylacetat, Butylacetat, Aceton.

Als Weichmacher werden dabei bevorzugt Flüssigkeiten mit guten Löseeigenschaften, geringer Flüchtigkeit und hoher Siedetemperatur eingesetzt. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Das erfindungsgemäße Verfahren zur Herstellung von Medien zur Aufzeichnung visueller Hologramme wird bevorzugt derart durchgeführt, dass die Aufbaukomponenten der erfindungsgemäßen Photopolymere homogen vermischt werden. Im bevorzugten Fall eines mittels Urethanbildung vernetzten Binders werden mit Ausnahme des Polyisocyanats alle Komponenten miteinander homogen vermischt und unmittelbar vor der Applikation auf das Substrat oder in die Form mit dem Polyisocyanat versetzt und vermischt.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C, ganz besonders bevorzugt 20 bis 40°C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente b) ist bevorzugt, um Blasenbildung durch Restgase in den erhältlichen Medien zu verhindern.

Vor Zumischung des Polyisocyanats können die Mischungen als lagerstabiles Zwischenprodukt gegebenenfalls über mehrere Monate gelagert werden kann.

Nach der Zumischung des Polyisocyanats wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung des Polyisocyanats bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Photopolymerzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 15000 mPas, insbesondere bevorzugt 500 bis 10000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Photopolymerzusammensetzungen der vorstehend genannten Art erwiesen, die in einer Menge von 15 g und mit einem Katalysatorgehalt von 0.004 Gew.-% bei 25°C unter 4 Stunden aushärten, bzw. bei einem Katalysatorgehalt von 0.02 % in weniger als 10 Minuten bei 25°C aushärten.

Zur Applikation auf ein Substrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck.

Mit den erfindungsgemäßen Photopolymerzusammensetzungen können durch entsprechende Belichtungsprozesse Hologramme für optische Anwendungen im gesamten sichtbaren und nahen UV-Bereich (300-800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Mögliche optische Funktionen der Hologramme, die mit den erfindungsgemäßen Photopolymerzusammensetzungen hergestellt werden können entsprechen den optische Funktionen von Lichtelemeten wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität je nachdem wie die Hologramme belichtet wurden und welche Dimensionen das Holgramm hat.

Zudem können mittels der erfindungsgemäßen Photopolymerzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellen Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

## Beispiele:

Sofern nicht abweichend vermerkt beziehen sich alle Prozentangaben auf Gewichtsprozent.

Beispiele 1-8c erläutern die Herstellung von Schreibmonomeren nach der allgemeinen Formel 1a/1b:

## Beispiel 1

156.5g Dibromphenylglycidether (Denacol EX147, erhältlich von Nagase ChemTex, Japan), 36g Acrylsäure 0,0019g 2,6-Di-t.-butyl-4-methylphenol und 0,328 Triphenylphosphin wurden in einem Dreihalskolben mit Rückflusskühler und Rührwerk vorgelegt. Zudem wurde Luft langsam durchgeleitet und auf 90C temperiert. Es wurde 60 h gerührt. Man erhielt ein klares, flüssiges Produkt, dass nach 1-H-NMR kein Epoxid mehr enthielt.

**Beispiel 1a**

30,8g des Produkts aus Beispiel 1 und 6,96g 2,4-Toluidendiisocyanat (Desmodur T100, Bayer MaterialScience AG, Leverkusen, Germany) wurden in einem Dreihalskolben mit Rückflusskühler und Rührwerk vorgelegt. Zudem wurde Luft langsam durchgeleitet und auf 60C temperiert. Nach anfänglicher Exothermie auf 80C wurde das Produkt für 80 Minuten bei 60C gerührt. Es wurde ein klares gläsernes Produkt mit NCO = 0% erhalten.

**Beispiel Ib-Id**

Die folgenden Beispiele wurden analog Beispiel 1a durchgeführt. Details hierzu finden sich in Tabelle 1

Tabelle 1:

| Beispiel | Rohstoff 1 Produkt Beispiel 1 | Rohstoff 2 Isocyanat | Rohstoff 3 | Reaktionszeit | Produkt |
|---|---|---|---|---|---|
| 1b | 26,95g | 5,88g HDI | - | 17h | klare, klebrige Masse |
| 1c | 26,95g | 7,35g TMDI | - | 17h | klare, klebrige Masse |
| 1d | 19,11g | 4,19g TIN | 0,01g KB | 17h | klares, bei Raumtemperatur sinterndes Glas |
| 1e | 26,95g | 40,81g RFE | 2 Tropfen DBTL nach 18h | 18h+4h | Ethylacetat wird abdestilliert dann klares, hochviskoses, klebriges Produkt |
| 1f | 26,95g | 9,17g W | - | 20h | klares, bei Raumtemperatur sinterndes Glas |
| 1g | 26,95g | 7,77g IPDI | - | 20h | ein klares, klebriges sinterndes Glas |
| 1h | 26,95g | 8,75g M44 | - | 20h | klares, klebriges sinterndes Glas |
| 1i | 23,10g | 10,63g XP2410 | - | 20.5h | klares, bei Raumtemperatur sinterndes Glas |

TDI: 2,4-Toluidendiisocyanat (Desmodur T100, Bayer MaterialScience AG, Leverkusen, Germany)

HDI: 2,6-Hexamethylendiisocyanat (Desmodur H, Bayer MaterialScience AG, Leverkusen, Germany)

TMDI: 2,4,4-Trimethyl-1,6-hexamethylendiisocyanat

TIN: Isocyanatomethyl-1,8-octandiisocyanat

RFE: 27% Lösung von Tris(p-isocyanatophenyl) thiophosphate in Ethylacetat (Desmodur RFE, Bayer MaterialScience AG, Leverkusen, Germany)

W: Gemisches aus Tris(4,4'- und 2,4'-) Diisocyanato-dicyclohexylmethan (Desmodur W, Bayer MaterialScience AG, Leverkusen, Germany)

IPDI: 1-Isocyanato-3-Isocyanatomethyl-3,5,5-trimethylcyclohexan (Desmodur I, Bayer MaterialScience AG, Leverkusen, Germany)

M44: Diisocyanato-dicyclohexylmethan (Desmodur M44, Bayer MaterialScience AG, Leverkusen, Germany)

XP2410: Trimerisats des Hexamethylendiisocyanats mit vorwiegend Iminooxadiazintrionstruktur (Desmodur XP2410, Bayer MaterialScience AG, Leverkusen, Germany)

T80: 80:20 Gemische aus 2,4- und 2,6-Toluidendiisocyanat (Desmodur T80, Bayer MaterialScience AG, Leverkusen,

Germany)

KB: 2,6-Di-t.-butyl-4-methylphenol

DBTL: Dibutylzinndilaurat

**Beispiel 2**

150,2g alpha-Naphtylglycidether (SACHEM Europe B.V.,ZALTBOMMEL, THE NETHERLANDS), 54g Acrylsäure, 0,492g Triphenylphosphin und 0,002g 2,6-Di-t.-butyl-4-methylphenol wurden in einem Dreihalskolben mit Rückflusskühler und Rührwerk vorgelegt. Zudem wurde Luft langsam durchgeleitet und auf 90C temperiert sowie 60 Stunden gerührt. Nach 1H-NMR enthielt das rötlich braune viskoses Produkt kein Epoxid mehr.

**Beispiel 2a-2d**

Die folgenden Beispiele wurden analog Beispiel 1a durchgeführt. Details hierzu finden sich in Tabelle 2

Tabelle 2: Abkürzungen siehe Tabelle 1

| Beispiel | Rohstoff 1 Produkt Beispiel 2 | Rohstoff 2 Isocyanat | Rohstoff 3 | Reaktionszeit | Produkt |
|---|---|---|---|---|---|
| 2a | 54,5g | 17,4g TDI | 0,014g KB | 0.5h | festes bräunliches gläsernes Produkt |
| 2b | 19,1g | 5,9g HDI | 0,002g DBTL | 19h | bräunlich klares, zähviskoses Produkt |
| 2c | 21,24g | 5,86g TIN | 0,0027g KB | 23h | bräunlich, klares, klebriges Produkt mit einem NCO Gehalt von 0.1% |
| 2d | 16,3g | 35g RFE | 0,005g DBTL | 19h | Ethylacetat wird abdestilliert, bräunlich klares, gläsernes Produkt |

**Beispiel 3**

93,9g Dibromphenylglycidether (Denacol EX147, erhältlich von Nagase ChemTex, Japan), 25,8g Methacrylsäure, 0,197g Triphenylphosphin und 0,0012g 2,6-Di-t.-butyl-4-methylphenol wurden in einem Dreihalskolben mit Rückflusskühler und Rührwerk vorgelegt. Zudem wurde Luft langsam durchgeleitet und auf 60C temperiert. Es wurde für 48h gerührt. Man erhielt ein gelblich klares, flüssiges Produkt mit OHZ=142 mg KOH/g.

**Beispiel 3a-3d**

Die folgenden Beispiele wurden analog Beispiel 1a durchgeführt. Details hierzu finden sich in Tabelle 3

Tabelle 3: Abkürzungen siehe Tabelle 1

| Beispiel | Rohstoff 1 Produkt Beispiel 3 | Rohstoff 2 Isocyanat | Rohstoff 3 | Reaktionszeit | Produkt |
|---|---|---|---|---|---|
| 3a | 27,7g | 6,1g TDI | 14,5g CHCl3 | 6h, dann 3mg DBTL | hellbraunes, klares, zähviskoses Produkt |
| 3b | 20,1g | 4,2g HDI | 0,002g DBTL | 19h | gelbliches, gläsernes Produkt |
| 3c | 27,7g | 5,9g TIN | 0,0027g KB | 20h, dann 5mg DBTL | gelbliches glasartiges Produkt |
| 3d | 20,1g | 29,2g RFE | 0,005g DBTL | 19h | Ethylacetat wird abdestilliert; klares, bei Raumtemperatur sinterndes Glas |

**Beispiel 4.1**

29,42g Maleinsäureanhydrid, 0,32g Triethylamin, 257g Toluol und 0,06g 2,6-Di-t.-butyl-4-methylphenol wurden in einem Dreihalskolben mit Rückflusskühler und Rührwerk vorgelegt. Zudem wurde Luft langsam durchgeleitet und auf 85C temperiert. Nun tropft man 34,84g Hydroxyethylacrylat innerhalb von 15 Minuten hinzu und rührt für 11 Stunden. Man befreit vom Lösungsmittel und erhielt eine klares, viskoses Produkt.

**Beispiel 4.2**

31,3g Dibromphenylglycidether (Denacol EX147, erhältlich von Nagase ChemTex, Japan), 21,4g des Produkts aus Beispiel 4.1, 0,066g Triphenylphosphin und 0,0005g 2,6-Di-t.-butyl-4-methylphenol wurden in einem Dreihalskolben mit Rückflusskühler und Rührwerk vorgelegt. Zudem wurde Luft langsam durchgeleitet und auf 90C temperiert und für 19 Stunden gerührt. Man erhielt ein klares flüssiges Produkt.

**Beispiel 4a-4d**

Die folgenden Beispiele wurden analog Beispiel 1a durchgeführt. Details hierzu finden sich in Tabelle 4

Tabelle 4: Abkürzungen siehe Tabelle 1

| Beispiel | Rohstoff 1 Produkt Beispiel 4.2 | Rohstoff 2 Isocyanat | Rohstoff 3 | Reaktionszeit | Produkt |
|---|---|---|---|---|---|
| 4a | 14,1g | 2,2g TDI | 14,5g CHCl3 | 20h, dann 5mg DBTL | gelblich, zähviskoses Produkt |
| 4b | 20,1g | 2,9g HDI | 0,002g DBTL | 17h | klare, klebrige Flüssigkeit |
| 4c | 14,1g | 2,1g TIN | | 3h, dann 5mg DBTL | klares, zähflüssiges Produkt |
| 4d | 18,9g | 19,2g RFE | 0,004g DBTL | 17h | Ethylacetat wird abdestilliert; klares, gläsernes Produkt |

**Beispiel 5**

112,7g Phenylglycidether, 54g Acrylsäure, 0,492g Triphenylphosphin und 0,0017g 2,6-Di-t.-butyl-4-methylphenol wurden in einem Dreihalskolben mit Rückflusskühler und Rührwerk vorgelegt. Zudem wurde Luft langsam durchgeleitet und auf 90C temperiert. Man rührte für 54 Stunden und erhielt ein klares, flüssiges, hochviskoses Produkt.

**Beispiel 5a-5d**

Die folgenden Beispiele wurden analog Beispiel 1a durchgeführt. Details hierzu finden sich in Tabelle 5

Tabelle 5: Abkürzungen siehe Tabelle 1

| Beispiel | Rohstoff 1 Produkt Beispiel 5 | Rohstoff 2 Isocyanat | Rohstoff 3 | Reaktionszeit | Produkt |
|---|---|---|---|---|---|
| 5a | 22,4g | 8,7g TDI | | 20h, dann 5mg DBTL | klares, hochviskoses Produkt |
| 5b | 22,4g | 8,4g HDI | 0,002g DBTL | 17h | klare, klebrige Flüssigkeit |
| 5c | 22,4g | 8,4g TIN | | 20h, dann 5mg DBTL | viskoses klares Produkt |
| 5d | 17,9g | 46,6g RFE | | 21h | Ethylacetat wird abdestilliert; leicht bräunlich klares, bei Raumtemperatur sinterendes Glas |

**Beispiel 6**

93,9g Dibromphenylglycidether (Denacol EX147, erhältlich von Nagase ChemTex, Japan), 43,2g 2-Carboxyethylacrylat, 0,197g Triphenylphosphin und 0,0014g 2,6-Di-t.-butyl-4-methylphenol wurden in einem Dreihalskolben mit Rückflusskühler und Rührwerk vorgelegt. Zudem wurde Luft langsam durchgeleitet, auf 90C temperiert und für 43 Stunden gerührt. Man erhielt ein kristallines, cremig, honigartiges Produkt mit OHZ=123,9 mg KOH/g.

**Beispiel 6a-6c**

Die folgenden Beispiele wurden analog Beispiel 1a durchgeführt. Details hierzu finden sich in Tabelle 6

Tabelle 6: Abkürzungen siehe Tabelle 1

| Beispiel | Rohstoff 1 Produkt Beispiel 6 | Rohstoff 2 Isocyanat | Rohstoff 3 | Reaktionszeit | Produkt |
|---|---|---|---|---|---|
| 6a | 20,7g | 3,9g T80 | 2mg DBTL | 19h | milchig weißer Feststoff |
| 6b | 20,7g | 3,8g HDI | 2mg DBTL | 19h | teilweise kristallisierten, klebrig zähviskoser Feststoff |
| 6c | 18,4g | 3,3g TIN | 2,2mg DBTL | 19h | teilweise kristallisierten, klebrig zähviskoser Feststoff |

**Beispiel 7**

70,1g alpha-Naphtylglycidether (SACHEM Europe B.V.,ZALTBOMMEL, THE NETHERLANDS), 50,4g 2-Carboxyethylacrylat, 0,459g Triphenylphosphin und 0,0012g 2,6-Di-t.-butyl-4-methylphenol wurden in einem Dreihalskolben mit Rückflusskühler und Rührwerk vorgelegt. Zudem wurde Luft langsam durchgeleitet und auf 90C temperiert. Man rührte 26 Stunden und erhielt eine bräunliche klare Flüssigkeit mit eine OHZ von 158 mg KOH/g.

**Beispiel 7a-7c**

Die folgenden Beispiele wurden analog Beispiel 1a durchgeführt. Details hierzu finden sich in Tabelle 7

Tabelle 7: Abkürzungen siehe Tabelle 1

| Beispiel | Rohstoff 1 Produkt Beispiel 6 | Rohstoff 2 Isocyanat | Rohstoff 3 | Reaktionszeit | Produkt |
|---|---|---|---|---|---|
| 7a | 17,8g | 4,4g T80 | 2mg DBTL | 17h | ein klares, bräunlich gläsernen Feststoff |
| 7b | 17,8g | 4,2g HDI | 2mg DBTL | 18h | braunrotes, teilkristallines Produkt |
| 7c | 17,8g | 4,2g TIN | 2,2mg DBTL | 18h | braunrotes, teilkristallines Produkt |

**Beispiel 8**

20,0g alpha-Naphtylglycidether (SACHEM Europe B.V.,ZALTBOMMEL, THE NETHERLANDS), 22,5g des Produktes aus Beispiel 4.1, 0,131g Triphenylphosphin und 0,043g 2,6-Di-t.-butyl-4-methylphenol wurden in einem Dreihalskolben mit Rückflusskühler und Rührwerk vorgelegt. Zudem wurde Luft langsam durchgeleitet und auf 90C temperiert und für 15 Stunden gerührt. Man erhielt eine rötlich, klare Flüssigkeit mit OHZ=135 mg KOH/g.

**Beispiel 8a-8c**

Die folgenden Beispiele wurden analog Beispiel 1a durchgeführt. Details hierzu finden sich in Tabelle 8

Tabelle 8: Abkürzungen siehe Tabelle 1

| Beispiel | Rohstoff 1 Produkt Beispiel 6 | Rohstoff 2 Isocyanat | Rohstoff 3 | Reaktionszeit | Produkt |
|---|---|---|---|---|---|
| 8a | 19,9g | 3,5g T80 | 2mg DBTL | 18h | braunrotes, klares bei Raumtemperatur sinterndes, gläsernes Produkt |
| 8b | 17,4g | 2,9g HDI | 2mg DBTL | 18h | braunrotes, klares, hochviskoses Produkt |
| 8c | 19,9g | 3,3g TIN | 2,3 mg DBTL | 18h | braunrotes, klares, hochviskoses Produkt |

Die oben beschriebenen Schreibmonomere wurden nun verwendet zur Herstellung der erfindungsgemäßen Photopolymere. Dabei wurde folgende Kompenenten verwendet.

Desmodur® XP 2410 ist ein Versuchsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %

Terathane® 1000 ist ein Handelsprodukt der Fa. BASF SE, Ludwigshafen, DE (Poly-THF der zahlenmittleren Molmasse 1000 g/Mol).

Polyol 1 ist ein difunktionelles Poly(ε-Caprolacton)-polyols (zahlenmittlere Molmasse ca. 650 g/Mol).

Alle anderen Polyole sind Handelsprodukte der Fa. Bayer MaterialScience AG, Leverkusen, DE und deren Zusammensetzung ist in den Beispielen bei Nennung beschrieben.

Fomrez® UL28: Urethanisierungskatalysator, Dimethylbis[(1-oxoneodecl)oxy]stannan, Handelsprodukt der Fa. Momentive Performance Chemicals, Wilton, CT, USA (als 10%ige Lösung in N-Ethylpyrrolidon eingesetzt).

CGI 909 ist ein im Jahr 2008 von der Fa. Ciba Inc., Basel, Schweiz vertriebenes Versuchsprodukt.

Herstellung von Polyol 1

In einem 1 L Kolben wurden 0.18 g Zinnoktoat, 374.8 g ε-Caprolacton und 374.8 g eines difunktionellen Polytetrahydrofuranpolyetherpolyols (Terathane® 1000, Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Messung der Brechungsindizes der photopolymerisierbaren Monomere**

Der Brechungsindex n in Abhängigkeit von der Wellenlänge der Proben wurden aus den Transmissions- und Reflexionsspektren erhalten. Dazu wurden ca. 100 - 300 nm dicke Filme der Proben auf Quarzglasträger aus verdünnter Lösung in Butylacetat aufgeschleudert. Das Transmissions- und Reflexionsspektrum dieses Schichtpaketes wurde mit einem Spektrometer der Firma STEAG ETA-Optik, CD-Measurement System ETA-RT gemessen und danach die Schichtdicke und der spektrale Verlauf von n an die gemessenen Transmissions- und Reflexionsspektren angepasst. Dies geschieht mit der internen Software des Spektrometers und erfordert zusätzlich die Brechungsindexdaten des Quarzglassubstrates, die in einer Blindmessung vorab bestimmt wurden. Der Brechungsindex $n_{Mo}$ bezieht sich auf die Wellenlänge von 405 nm und entspricht damit $n_D^{20}$.

**Messung der holographischen Eigenschaften DE und Δn der holographischen Medien mittels Zweistrahlinterferenz in Reflexionsanordnung**

Die wie im Abschnitt "Herstellung der holographischen Medien basierend auf Photopolymerformulierung mit Photoinitiatator zur Bestimmung der Performance Parameter DE und Δn" beschrieben hergestellten Medien wurden anschließend mittels einer Messanordnung gemäß Figur 1 wie folgt auf ihre holographischen Eigenschaften geprüft: Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel

($\alpha$) des Referenzstrahls beträgt 21.8°, der Einfallswinkel ($\beta$) des Signalstrahl beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen).

Figur 1 zeigt den holographischen Versuchsaufbau, mit dem die Beugungseffizienz (DE) der Medien gemessen wurde. Figur 1 zeigt die Geometrie eines HMT bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha$ = 21.8°, $\beta$ = 41.8° sind die Einfallswinkel der kohärenten Strahlen ausserhalb der Probe (des Mediums) gemessen.

Es wurden auf folgende Weise Hologramme in das Medium geschrieben:

- Beide Shutter (S) sind für die Belichtungszeit t geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man das für alle Drehwinkel ($\Omega$) des Mediums der Strahl immer vollständig im zuvor geschriebenen Hologramm lag. Der Drehtisch überstrich nun computergesteuert den Winkelbereich von $\Omega$ = 0° bis $\Omega$ = 20° mit einer Winkelschrittweite von 0.05°. An jedem angefahrenen Winkel Ω□□□ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels Ω□□ des geschriebenen Hologramms gemessen und in einem Computer gespeichert. Zusätzlich wurde auch die in die nullte Ordnung transmittierte Intensität gegen der Drehwinkel $\Omega$ aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast $\Delta$n und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve $\eta(\Omega)$ eines Reflexionshologramms gilt nach Kogelnik:

$$\eta = \frac{1}{1 + \frac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha), n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\Psi$ der Kippwinkel des Brechungsindexgitters das geschrieben wurde. $\alpha'$ und $\beta'$ entsprechen den Winkeln $\alpha$ und $\beta$ beim Schreiben des Hologramms, aber im Medium gemessen. $\Delta$ ist das Winkeldetuning gemessen im Medium, also die Abweichung vom Winkel $\alpha'$. $\Delta\Omega$ ist das Winkeldetuning gemessen ausserhalb des Mediums, also die Abweichung vom Winkel $\alpha$. n ist der mittlere Brechungsindex des Photopolymers und wurde zu 1.504 gesetzt. $\lambda$ ist die Wellenlänge des Laserlichts im Vakuum.

Die maximale Beugungseffizienz (DE = $\eta_{max}$) ergibt sich dann für $\chi$ = 0, also $\Delta\Omega$ = 0 zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

Die Messdaten der Beugungseffizienz, die theoretische Braggkurve und die transmittierte Intensität werden wie in Figure 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta$n wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Holgrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2 zeigt die Darstellung der Braggkurve $\eta$ nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt aus den Leistungen der zwei den Winkeln $\alpha$ und $\beta$ zugeordneten Teilstrahlen ($P_\alpha$ = 0.50 mW und $P_\square$ = 0.67 mW), der Belichtungszeit t und dem Durchmesser der Irisblende (0.4 cm):

$$E\,(\text{mJ/cm}^2) = \frac{2 \cdot \lfloor P_\alpha + P_\beta \rfloor \cdot t\,(\text{s})}{\pi \cdot 0.4^2\ \text{cm}^2}$$

Die Leistungen der Teilstrahlen wurden so angepasst, dass in dem Medium bei den verwendeten Winkeln $\alpha$ und $\beta$, die gleiche Leistungsdichte erreicht wird.

**Allgemeine Vorschrift zur Herstellung der holografischen Medien für Beispiele 9-41**

5,927 g des oben beschrieben hergestellten Polyols 1 wurden mit 2.5 g des entsprechenden Schreibmonomers, 0.1 g CGI 909, 0.01 g Neu Methylenblau, 0,015g Glasperlen der Größe 20 µm (z. B. der Fa. Whitehouse Scientific Ltd, Waverton, Chester, CH3 7PB, United Kingdom) bei 60 °C und 0.35 g N-Ethylpyrolidon gemischt, so dass eine klare Lösung erhalten wurde. Anschließend wurde auf 30 °C abgekühlt, 1.098 g Desmodur® XP 2410 (Komponente A) zugegeben und erneut gemischt. Schließlich wurden 0.006 g Fomrez® UL 28 zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 µm gehalten wurde. Die Härtung der PU-Formulierung erfolgt unter 15 kg Gewichten über mehrere Stunden (gewöhnlich über Nacht). Teilweise wurden die Medien in lichtdichter Verpackung noch 2 Stunden bei 60 °C nachgehärtet. Die Dicke d der Photopolymerschicht ergibt sich aus dem Durchmesser der verwendeten Glaskugeln zu 20 µm. Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führen, wird d anhand der Charakteristika der geschriebenen Hologramme für jede Probe separat ermittelt.

Tabelle 9 stellt nun die holografischen Ergebnisse der Medien auf Basis der erfindungsgemäßen Photopolymere dar:

Tabelle 9: Holografische Performance der erfindungsgemäßen Medien der Beispiele 9-41, SM: Schreibmonomer, RI: Brechungsindex

| Beispiel # | SM aus Beispiel | RI des SM | Delta n | Dicke (µm) | Belichtungsdauer (s) |
|---|---|---|---|---|---|
| Beispiel 9 | 1a | 1,651 | 0.010 | 25 | 4 |
| Beispiel 10 | 1b | 1,590 | 0.009 | 23 | 2 |
| Beispiel 11 | 1c | 1,593 | 0.007 | 40 | 4 |
| Beispiel 12 | 1d | 1,600 | 0.008 | 28 | 4 |
| Beispiel 13 | 1e | 1,633 | 0.008 | 26 | 4 |
| Beispiel 14 | 1f | 1,580 | 0.007 | 24 | 2 |
| Beispiel 15 | 1g | 1,590 | 0.007 | 22 | 2 |
| Beispiel 16 | 1h | 1,639 | 0.007 | 26 | 4 |
| Beispiel 17 | 1i | 1,588 | 0.006 | 28 | 2 |
| Beispiel 18 | 2a | 1,656 | 0.007 | 22 | 2 |
| Beispiel 19 | 2b | 1,611 | 0.008 | 19 | 4 |
| Beispiel 20 | 2c | 1,625 | 0.009 | 24 | 4 |
| Beispiel 21 | 2d | 1,656 | 0.008 | 27 | 4 |
| Beispiel 22 | 3a | 1,629 | 0.008 | 21 | 2 |
| Beispiel 23 | 3b | 1,600 | 0.009 | 28 | 4 |
| Beispiel 24 | 3c | 1,604 | 0.010 | 32 | 2 |
| Beispiel 25 | 3d | 1,637 | 0.010 | 23 | 4 |
| Beispiel 25 | 4a | 1,609 | 0.008 | 22 | 4 |
| Beispiel 26 | 4b | 1,587 | 0.007 | 18 | 2 |
| Beispiel 27 | 4c | 1,575 | 0.008 | 25 | 2 |

(fortgesetzt)

| Beispiel # | SM aus Beispiel | RI des SM | Delta n | Dicke (μm) | Belichtungsdauer (s) |
|---|---|---|---|---|---|
| Beispiel 28 | 4d | 1,599 | 0.006 | 21 | 2 |
| Beispiel 29 | 5a | 1,612 | 0.012 | 23 | 4 |
| Beispiel 30 | 5b | 1,558 | 0.009 | 16 | 4 |
| Beispiel 31 | 5c | 1,569 | 0.008 | 23 | 4 |
| Beispiel 32 | 5d | 1,627 | 0.009 | 33 | 4 |
| Beispiel 33 | 6a | 1,622 | 0.010 | 30 | 2 |
| Beispiel 34 | 6b | 1,585 | 0.009 | 17 | 2 |
| Beispiel 35 | 6c | 1,570 | 0.008 | 19 | 4 |
| Beispiel 36 | 7a | 1,623 | 0.008 | 20 | 2 |
| Beispiel 37 | 7b | 1,593 | 0.007 | 18 | 4 |
| Beispiel 38 | 7c | 1,599 | 0.005 | 18 | 2 |
| Beispiel 39 | 8a | 1,620 | 0.007 | 22 | 4 |
| Beispiel 40 | 8b | 1,603 | 0.007 | 15 | 4 |
| Beispiel 41 | 8c | 1,601 | 0.006 | 26 | 4 |

Die Photopolymere in den erfindungsgemäßen Medien aus den Beispielen 9-41 sind alle optisch klarer Natur und es können Volumenhologramme bei Raumtemperatur ausschließlich durch Einwirkung von kohärenter Strahlung eingeschrieben werden. Es ist wie von der Aufgabestellung gefordert unter Verzicht auf thermischer und/oder chemischer Nachbehandlung möglich visuelle Hologramme einzuschreiben.

**Patentansprüche**

1. Photopolymerzusammensetzungen umfassend

   a) mindestens ein ungesättigtes Glycidyletheracrylaturethan der allgemeinen Formel (1a) oder (1b) oder Mischungen aus (1a) und (1b)

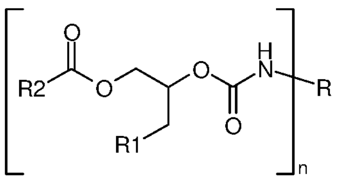

Formel 1a

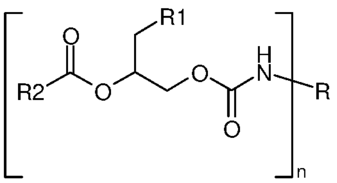

Formel 1b

   wobei

   n eine natürliche Zahl von 2 bis 6 ist

R1 ein ein- oder mehrkerniger Aromatengruppen haltiger organischer Rest mit 4 bis 36 Kohlenstoffatomen ist,
R2 ein olefinisch ungesättigter Rest mit 3 bis 30 Kohlenstoffatomen ist und
R ein von einem aliphatischen oder aromatischen Di- oder Polyisocyanat abgeleiteter organischer Rest mit 2 bis 30 Kohlenstoffatomen ist.

b) ein Bindersystem
c) mindestens ein Photoinitiatorsystem
d) ggf. Radikalstabilisatoren, Katalysatoren und weitere Zusatzstoffe,

**dadurch gekennzeichnet, dass** das Photoinitiatorsystem aus einer Mischung aus einem Ammoniumarylborat und einem oder mehreren Farbstoffen besteht, wobei in b) vernetzte Binder eingesetzt werden, wobei dass der vernetzte Binder ein zweikomponentiges Polyurethansystem ist und das zweikomponentige Polyurethansystem als Isocyanatkomponente Oligo- und Polyisocyanate aliphatischer Diisocyanate mit Isocyanurat-, Allophanat-, Biuret-, Uretdion-, Iminooxadiazindionstruktur und die Polyolkomponente Polyethylen/Polypropylenglykole mit einem Polypropylengehalt von mindestens 70% und einer Funktionalität von 1.9 bis 2.5 und/oder Polyester-Polyether-Polyester-Blockpolyole auf Basis von Polytetrahydrofuranen mit einem zahlenmittleren Molekulargewicht von 400 bis 1400 g/mol und ε-Caprolacton umfasst, wobei diese Polyester-Polyether-Polyester-Blockpolyole ein zahlenmittleres Molekulargewicht von 1500 bis 4000 g/mol haben.

**2.** Photopolymerzusammensetzungen gemäß Anspruch 1, **dadurch gekennzeichnet, dass**

R1 Oxy-phenyl, Oxy-bromphenyl, Oxy-dibromphenyl oder Oxy-naphtyl ist,
R2 von einer Säure R2-COOH abgeleitet ist und R2-COOH Acrylsäure, Methacrylsäure, 3-Acryloxypropionsäure oder ein Addukt von Hydroxyethyl- und Hydroxybutylacrylat mit Maleinsäureanhydrid ist und
R von einem n-funktionellen Isocyanat $R(NCO)_n$ abgeleitet ist und $R(NCO)_n$ 2,6-Hexamethylendiisocyanat, 2,4,4-Trimethyl-1,6-hexamethylendiisocyanat, Isocyanatomethyl-1,8-octandiisocyanat, Tris(p-isocyanatophenyl) thiophosphate, Tris(4,4'- und/oder 2,4'-) Diisocyanato-dicyclohexylmethan, 1-Isocyanato-3-Isocyanatomethyl-3,5,5-trimethylcyclohexan, Diisocyanato-dicyclohexylmethan 2,4- und/oder 2,6-Toluidendiisocyanat oder Trimerisate des Hexamethylendiisocyanats mit Isocyanurat und / oder Iminooxadiazintrionstruktur ist.

**3.** Photopolymerzusammensetzungen gemäß Anspruch 1 oder 2, **dadurch gekennzeichnet, dass** die in a) eingesetzten Glycidyletheracrylaturethane einen Brechungsindex bei 405 nm von größer als 1,53 aufweisen.

**4.** Verfahren zur Herstellung von Medien zur Aufzeichnung visueller Hologramme, bei dem die Photopolymerzusammensetzungen gemäß einem der Ansprüche 1 bis 3 auf ein Substrat oder in eine Form appliziert und ausgehärtet werden.

**5.** Medien zur Aufzeichnung visueller Hologramme erhältlich nach einem Verfahren gemäß Anspruch 4.

**6.** Verwendung von Medien gemäß Anspruch 5 als optische Elemente, Bilder oder zur Bilddarstellung oder -projektion.

**7.** Verfahren zur Aufzeichnung eines Hologramms, bei dem Medien gemäß Anspruch 5 eingesetzt werden.

## Claims

**1.** Photopolymer compositions comprising

a) at least one unsaturated glycidyl ether acrylate urethane of the general formula (1a) or (1b) or mixtures of (1a) and (1b)

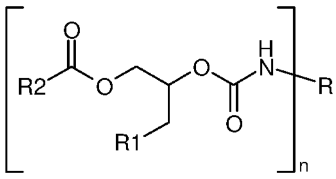

formula 1a

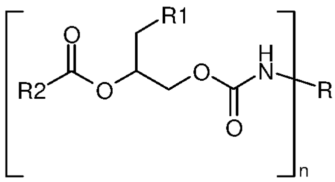

formula 1b

in which

n is a natural number from 2 to 6,
R1 is a mono- or polynuclear organic radical containing aromatic groups and having 4 to 36 carbon atoms,
R2 is an olefinically unsaturated radical having 3 to 30 carbon atoms and
R is an organic radical derived from aliphatic or aromatic di- or polyisocyanate and having 2 to 30 carbon atoms,

b) a binder system
c) at least one photoinitiator system
d) optionally free radical stabilizers, catalysts and further additives,

**characterized in that** the photoinitiator system consists of a mixture of an ammonium arylborate and one or more dyes, wherein crosslinked binders are used in b), wherein the crosslinked binder is a two-component polyurethane system and the two-component polyurethane system comprises, as the isocyanate component, oligo- and polyisocyanates of aliphatic diisocyanates having an isocyanurate, allophanate, biuret, uretdione or iminooxadiazinedione structure, and the polyol component comprises polyethylene/polypropylene glycols having a polypropylene content of at least 70% and a functionality of 1.9 to 2.5 and/or polyester-polyether-polyester block polyols based on polytetrahydrofurans having a number average molecular weight of 400 to 1400 g/mol and ε-caprolactone, these polyester-polyether-polyester block polyols having a number average molecular weight of 1500 to 4000 g/mol.

**2.** Photopolymer compositions according to Claim 1, **characterized in that**

R1 is oxyphenyl, oxybromophenyl, oxydibromophenyl or oxynaphthyl,
R2 is derived from an acid R2-COOH, and R2-COOH is acrylic acid, methacrylic acid, 3-acrylyloxypropionic acid or an adduct of hydroxyethyl and hydroxybutyl acrylate with maleic anhydride, and
R is derived from an n-functional isocyanate $R(NCO)_n$, and $R(NCO)_n$ is 2,6-hexamethylene diisocyanate, 2,4,4-trimethyl-1,6-hexamethylene diisocyanate, isocyanatomethyl-1,8-octane diisocyanate, tris(p-isocyanatophenyl) thiophosphates, tris(4,4'- and/or 2,4'-) diisocyanatodicyclohexylmethane, 1-isocyanato-3-isocyanatomethyl-3,5,5-trimethylcyclohexane, diisocyanatodicyclohexylmethane 2,4- and/or 2,6-toluidene diisocyanate or trimers of hexamethylene diisocyanate having an isocyanurate and/or iminooxadiazinetrione structure.

**3.** Photopolymer compositions according to Claim 1 or 2, **characterized in that** the glycidyl ether acrylate urethanes used in a) have a refractive index at 405 nm of greater than 1.53.

**4.** Process for the production of media for recording visual holograms, in which the photopolymer compositions according to any of Claims 1 to 3 are applied to a substrate or in a mould and are cured.

**5.** Media for recording visual holograms, obtainable by a process according to Claim 4.

**6.** Use of media according to Claim 5 as optical elements, or images or for image representation or projection.

7. Method for recording a hologram, in which media according to Claim 5 are used.

## Revendications

1. Compositions de photopolymère comprenant :

   a) au moins un glycidyl-éther-acrylate-uréthane insaturé de la formule générale (1a) ou (1b) ou des mélanges de (1a) et (1b)

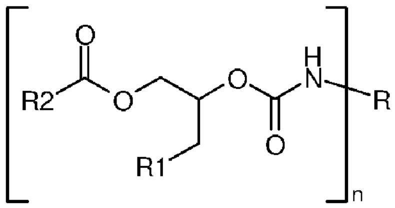

Formule 1a

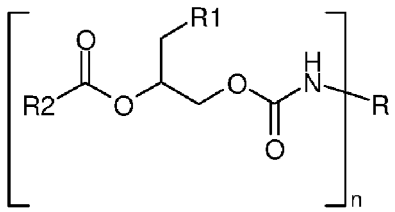

Formule 1b

   dans lesquelles

   n est un nombre naturel de 2 à 6,
   R1 est un radical organique contenant des groupes aromatiques mono- ou polynucléaires de 4 à 36 atomes de carbone,
   R2 est un radical oléfiniquement insaturé de 3 à 30 atomes de carbone, et
   R est un radical organique dérivé d'un di- ou polyisocyanate aliphatique ou aromatique de 2 à 30 atomes de carbone,

   b) un système de liant,
   c) au moins un système de photoinitiateur,
   d) éventuellement des stabilisateurs de radicaux, des catalyseurs et des additifs supplémentaires,

   **caractérisées en ce que** le système de photoinitiateur est constitué par un mélange d'un arylborate d'ammonium et d'un ou de plusieurs colorants, des liants réticulés étant utilisés en b), le liant réticulé étant un système de polyuréthane bicomposant et le système de polyurétane bicomposant comprenant en tant que composant isocyanate des oligo- et polyisocyanates de diisocyanates aliphatiques contenant une structure isocyanurate, allophanate, biuret, uretdione, iminooxadiazine-dione, et en tant que composant polyol des polyéthylène/polypropylène glycols ayant une teneur en polypropylène d'au moins 70 % et une fonctionnalité de 1,9 à 2,5 et/ou des polyols séquencés de polyester-polyéther-polyester à base de polytétrahydrofuranes ayant un poids moléculaire moyen en nombre de 400 à 1 400 g/mol et d'ε-caprolactone, ces polyols séquencés de polyester-polyéther-polyester ayant un poids moléculaire moyen en nombre de 1 500 à 4 000 g/mol.

2. Compositions de photopolymère selon la revendication 1, **caractérisées en ce que**
   R1 est oxy-phényle, oxy-bromophényle, oxydibromophényle ou oxy-naphtyle,
   R2 est dérivé d'un acide R2-COOH et R2-COOH est l'acide acrylique, l'acide méthacrylique, l'acide 3-acryloxypropionique ou un adduit d'acrylate d'hydroxyéthyle et d'hydroxybutyle avec de l'anhydride de l'acide maléique, et
   R est dérivé d'un isocyanate n-fonctionnel $R(NCO)_n$ et $R(NCO)_n$ est le diisocyanate de 2,6-hexaméthylène, le diisocyanate de 2,4,4-triméthyl-1,6-hexaméthylène, le diisocyanate d'isocyanato-méthyl-1,8-octane, le thiophoshate

de tris(p-isocyanatophényle), le tris(4,4'- et/ou 2,4'-)diisocyanato-dicyclohexylméthane, le 1-isocyanato-3-isocyanatométhyl-3,5,5-triméthylcyclohexane, le diisocyanato-dicyclohexylméthane, le diisocyanate de 2,4- et/ou 2,6-toluidène ou des trimères de diisocyanate d'hexaméthylène contenant une structure isocyanurate et/ou iminooxadiazine-trione.

3. Compositions de photopolymère selon la revendication 1 ou 2, **caractérisées en ce que** les glycidyl-éther-acrylate-uréthanes utilisés en a) présentent un indice de réfraction à 405 nm de plus de 1, 53.

4. Procédé de fabrication de supports pour l'enregistrement d'hologrammes visuels, selon lequel les compositions de photopolymère selon l'une quelconque des revendications 1 à 3 sont appliquées sur un substrat ou dans un moule et durcies.

5. Supports pour l'enregistrement d'hologrammes visuels pouvant être obtenus par un procédé selon la revendication 4.

6. Utilisation de supports selon la revendication 5 en tant qu'éléments optiques, images ou pour l'affichage ou la projection d'images.

7. Procédé d'enregistrement d'un hologramme, selon lequel des supports selon la revendication 5 sont utilisés.

**Figur 1:**

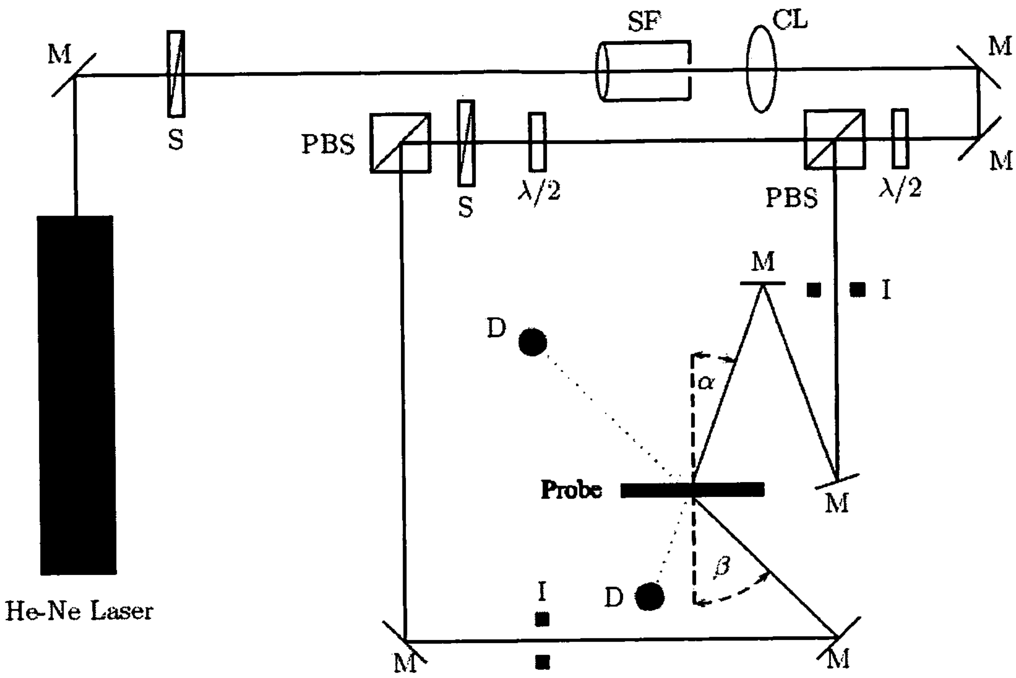


**Figur 2:**

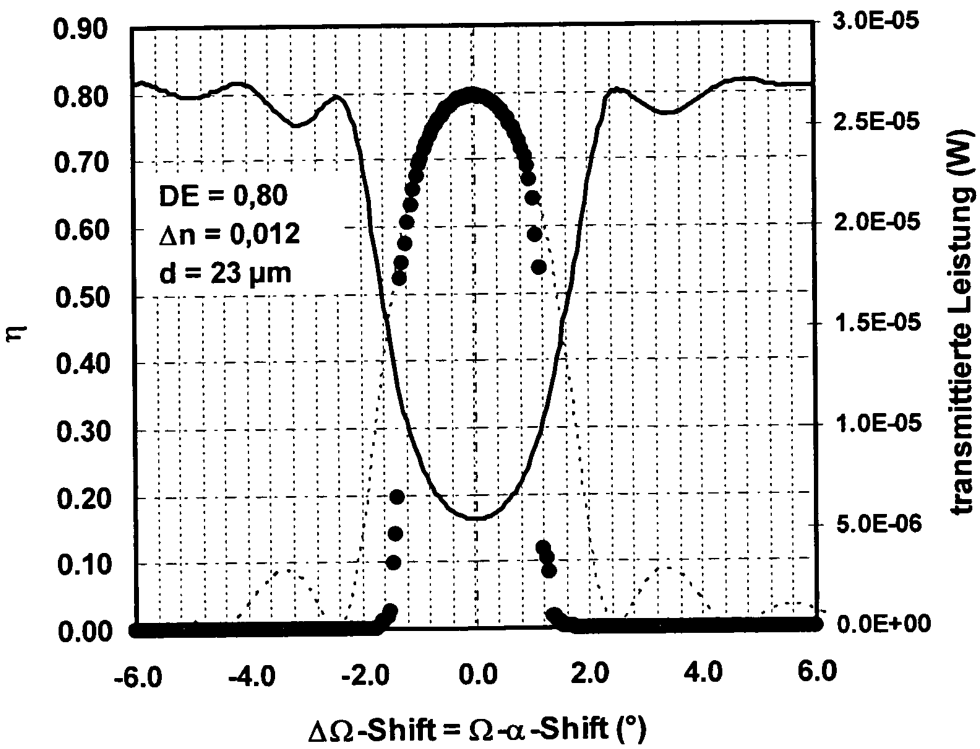

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 44352 A
- JP 118475 A
- JP 2006243416 B
- US 4959284 A
- EP 352774 A1
- US 6103454 A
- JP 2005239925 A
- JP 2005194476 A
- JP 2004118050 A
- JP 2004342537 A
- EP 0223587 A


### In der Beschreibung aufgeführte Nicht-Patentliteratur


- Methoden der organischen Chemie'' (Houben-Weyl). Georg Thieme Verlag, 1961, vol. XIV/1, 433ff
- **H. KOGELNIK.** *The Bell System Technical Journal,* November 1969, vol. 48 (9), 2909-2947